(19) Europäisches Patentamt
European Patent Office
Office européen des brevets

(11) EP 4 776 825 A1

(12) EUROPEAN PATENT APPLICATION
published in accordance with Art. 153(4) EPC

(43) Date of publication:
15.07.2026 Bulletin 2026/29

(51) International Patent Classification (IPC):
H10N 97/00 (2023.01)    H10D 84/00 (2025.01)

(21) Application number: 24863104.6

(52) Cooperative Patent Classification (CPC):
H10D 84/00; H10N 97/00

(22) Date of filing: 27.08.2024

(86) International application number:
PCT/KR2024/012789

(87) International publication number:
WO 2025/053523 (13.03.2025 Gazette 2025/11)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 07.09.2023 KR 20230119025

(71) Applicant: LG Innotek Co., Ltd.
Seoul 07796 (KR)

(72) Inventors:
• KIM, Tae Hoon
  Seoul 07796 (KR)
• PARK, Jin Gyeong
  Seoul 07796 (KR)
• KIM, Kab Young
  Seoul 07796 (KR)

(74) Representative: DREISS Patentanwälte PartG mbB
Friedrichstraße 6
70174 Stuttgart (DE)

(54) CAPACITOR

(57) A capacitor according to one embodiment of the present invention comprises: a base including a through-hole penetrating from a first surface to a second surface opposite the first surface; a first electrode layer disposed on the first surface, the second surface, and an inner wall surface of the through-hole of the base; a first dielectric layer disposed on the first electrode layer on the first surface, the second surface, and the inner wall surface of the through-hole of the base, and a second electrode layer disposed on the first dielectric layer on the first surface, the second surface, and the inner wall surface of the through-hole of the base, wherein the base includes silicon, and the surface roughness of the inner wall surface of the through-hole is 1 nm to 50 nm.

FIG. 3

**Description**

[Technical Field]

An embodiment of the present invention relates to a capacitor.

[Background Art]

Semiconductor packages are applied to various fields such as vehicles, communications, and computers, and generally include a printed circuit board, a semiconductor chip disposed on the printed circuit board, and a passive element disposed on the printed circuit board. The passive element may include, for example, a resistor, an inductor, a capacitor, etc.
As semiconductor packages become more advanced, demands for a capacitor having high performance, high reliability, and ultra-small size are increasing. In order to satisfy such demands, a silicon-based capacitor and an anodic aluminum oxide (AAO)-based capacitor have been proposed. The silicon-based capacitor includes an electrode layer, a dielectric layer, and an electrode layer that are sequentially stacked on a silicon base, and the AAO-based capacitor includes an electrode layer, a dielectric layer, and an electrode layer that are sequentially stacked on an AAO base.
As a need for reducing a signal path of the semiconductor package and reducing a size of the semiconductor package increases, a high-capacitance capacitor that can be mounted inside or underneath the semiconductor package is required.

[Disclosure]

[Technical Problem]

A technical object of the present invention is to provide an ultra-small and high-capacitance capacitor.

[Technical Solution]

A capacitor according to an embodiment of the present invention includes: a base including a through-hole penetrating from a first surface to a second surface opposite to the first surface; a first electrode layer disposed on the first surface, the second surface, and an inner wall surface of the through-hole of the base; a first dielectric layer disposed on the first electrode layer on the first surface, the second surface, and the inner wall surface of the through-hole of the base; and a second electrode layer disposed on the first dielectric layer on the first surface, the second surface, and the inner wall surface of the through-hole of the base, wherein the base includes silicon, and a surface roughness of the inner wall surface of the through-hole is 1 nm to 50 nm.
The roughness of the inner wall surface of the through-hole may be 10 nm to 30 nm.
At least one of the first surface or the second surface may include a porous region.
A surface roughness of at least one of the first surface or the second surface may be different from the roughness of the inner wall surface of the through-hole.
The surface roughness of the first surface may be different from the surface roughness of the second surface.
When the through-hole is divided into an upper region, a middle region, and a lower region with having equal heights from the first surface to the second surface of the base, a surface roughness of an inner wall surface of the middle region may be 0.9 to 1.1 times a surface roughness of an inner wall surface of the upper region and 0.9 to 1.1 times a surface roughness of an inner wall surface of the lower region.
When the through-hole is divided into an upper region, a middle region, and a lower region having equal heights from the first surface to the second surface of the base, a diameter of the middle region may be 0.9 to 1.1 times a diameter of the upper region and 0.9 to 1.1 times a diameter of the lower region.
The first electrode layer and the second electrode layer may include at least one of titanium (Ti), molybdenum (Mo), tungsten (W), indium-tin, or copper (Cu).
The capacitor may further include a passivation layer disposed on the second electrode layer, wherein the passivation layer may include $SiO_2$.
A length of the plurality of through-holes in a direction from the first surface toward the second surface may be 3.5 $\mu$m or greater and 175 $\mu$m or less.
A silicon substrate according to an embodiment of the present invention may include a base including a through-hole penetrating from a first surface to a second surface opposite to the first surface, wherein the base may include silicon, a surface roughness of an inner wall surface of the through-hole may be 1 nm to 50 nm, and wherein, when the through-hole is divided into an upper region, a middle region, and a lower region having equal heights from the first surface to the second surface of the base, a surface roughness of an inner wall surface of the middle region may be 0.9 to 1.1 times a surface roughness of an inner wall surface of the upper region and 0.9 to 1.1 times a surface roughness of an inner wall surface of the lower region.

A silicon substrate according to another embodiment of the present invention may include a base including a through-hole penetrating from a first surface to a second surface opposite to the first surface, wherein the base may include silicon, wherein a surface roughness of the inner wall surface of the through-hole may be 1 nm to 50 nm, and wherein, when the through-hole is divided into an upper region, a middle region, and a lower region having equal heights from the first surface to the second surface of the base, a diameter of the middle region may be 0.9 to 1.1 times a diameter of the upper region and 0.9 to 1.1 times a diameter of the lower region.

[Advantageous Effects]

According to an embodiment of the present invention, an ultra-small high-capacitance capacitor can be provided. In addition, according to an embodiment of the present invention, a capacitor having a simple manufacturing process, low cost, and high reliability can be provided.

[Description of Drawings]

FIG. 1 is a perspective view of a capacitor according to an embodiment of the present invention.
FIG. 2 is a perspective view of a base included in the capacitor according to an embodiment of the present invention.
FIG. 3 is a cross-sectional view of the base included in the capacitor according to an embodiment of the present invention.
FIGS. 4 to 7 are cross-sectional views of the capacitor according to an embodiment of the present invention.
FIG. 8 shows a method of forming a through-hole of the base according to an embodiment of the present invention.
FIGS. 9 to 10 are views for describing an etching mechanism in a process of forming the through-hole of the base according to an embodiment of the present invention.
FIGS. 11 to 13 are SEM images of a structure manufactured according to an embodiment of the present invention.
FIGS. 14 to 15 are cross-sectional views of a capacitor according to another embodiment of the present invention.

[Modes of the Invention]

Hereinafter, exemplary embodiments of the present invention will be described in detail with reference to the accompanying drawings.

However, the spirit of the present invention is not limited to the embodiments described below, and the present invention may be embodied in various forms. One or more components of the embodiments may be selectively combined or substituted with one another within the spirit or scope of the present invention.

In addition, the terminology used in the embodiments of the present invention, including technical and scientific terms, unless explicitly defined otherwise, will be interpreted as having meanings that are generally understood by those of ordinary skilled in the art to which the present invention pertains, and terms having meanings commonly understood, such as those defined in dictionaries, will be interpreted in the context of the related technologies.

In addition, the terminology used in the embodiments of the present invention is used for the purpose of describing the embodiments only and is not intended to limit the scope of the present invention.

In the present specification, the singular forms can be understood to include plural forms unless otherwise indicated, and the expression "at least one of A, B, and/or C" can be understood to include any combination of one or more A, B, and C.

In addition, expressions such as "first," "second," "A," "B," "(a)," and "(b)," may be used to describe components of embodiments of the present invention for convenience of description.

These expressions are used solely to distinguish one component from another, and do not limit the substance, order, or arrangement of the corresponding components.

Furthermore, when a component is described as being "connected," "combined," or "joined" to another component, the description should be understood to include that the component is "connected," "combined," or "accessed" to the other component not only directly, but also indirectly through one or more intervening components.

In expression "formed or disposed "on (over) or under (below)" another component," the terms "on (over)" and "under (below)" include not only a direct contact between two components, but also formation or disposition in which one or more other components are interposed between the two components. Furthermore, the terms "on (over)" and "under (below)" may refer to both upper and lower directions relative to one component.

Hereinafter, embodiments of the present invention will be described in detail with reference to the accompanying drawings. The same reference numerals refer to the same or corresponding components throughout the drawings, and redundant descriptions thereof will be omitted.

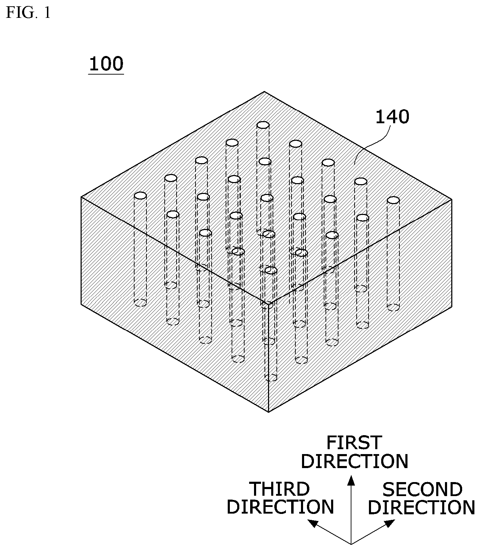

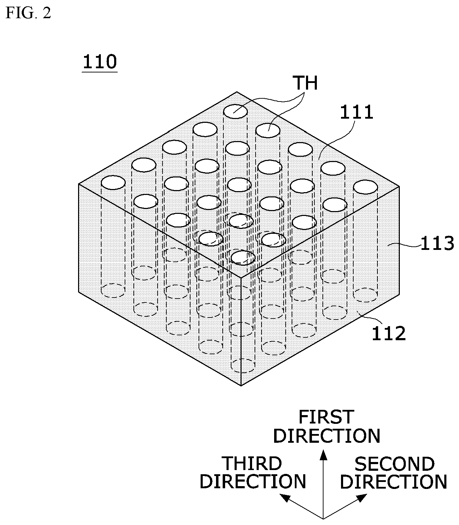

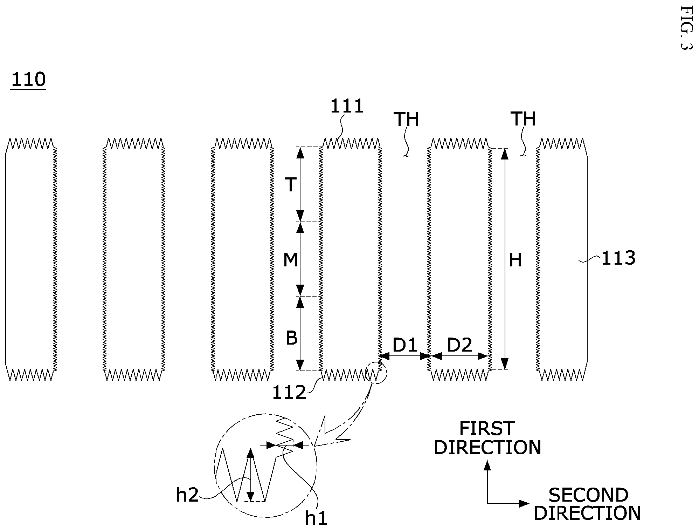

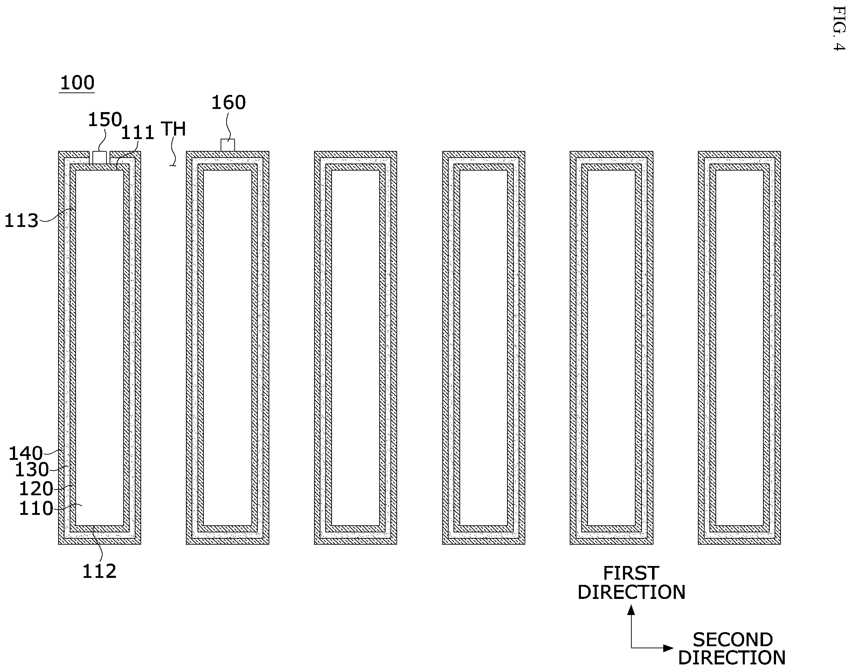

FIG. 1 is a perspective view of a capacitor according to an embodiment of the present invention, FIG. 2 is a perspective view of a base included in the capacitor according to an embodiment of the present invention, FIG. 3 is a cross-sectional view of the base included in the capacitor according to an embodiment of the present invention, and FIGS. 4 to 7 are cross-sectional views of the capacitor according to an embodiment of the present invention.

Referring to FIGS. 1 to 7, a capacitor 100 includes a base 110, a first electrode layer 120, a first dielectric layer 130, and a second electrode layer 140.

As shown in FIGS. 2 and 3, the base 110 includes a first surface 111, a second surface 112 opposite to the first surface 111, and a third surface 113 disposed between the first surface 111 and the second surface 112. The first surface 111, the second surface 112, and the third surface 113 may be referred to as an upper surface, a lower surface, and a side surface, respectively. The base 110 is illustrated as having a hexahedral shape, but is not limited thereto. The base 110 may be in a cylinder, an elliptical cylinder, a prism, or the like.

The base 110 may include a semiconductor material or a non-conductor material. For example, the base 110 may be a silicon (Si) substrate. For example, the base 110 may be a doped silicon substrate. For example, the base 110 may be an n-type doped silicon substrate or a p-type doped silicon substrate. Accordingly, the base 110 according to an embodiment of the present invention may be referred to as a silicon substrate.

According to an embodiment of the present invention, the base 110 includes a plurality of through-holes TH penetrating from the first surface 111 to the second surface 112. In other words, the plurality of through-holes TH extend from the first surface 111 to the second surface 112 of the base 110. In this case, at least some of the plurality of through-holes TH may be parallel to each other. For example, an imaginary line connecting from the center of a bottom surface to the center of a top surface of one of the plurality of through-holes TH may be parallel to an imaginary line connecting from the center of a top surface to the center of a top surface of the other one of the plurality of through-holes TH. Accordingly, since electrode layers may be easily deposited with a uniform thickness on inner wall surfaces of the plurality of through-holes TH, a high-reliability capacitor may be provided. The plurality of through-holes TH may be formed by a method of etching a silicon substrate. The plurality of through-holes TH may have the same shape or a regular shape, and separation distances between the plurality of through-holes TH may be the same as each other, or may have a pattern that regularly increases or regularly decreases.

According to an embodiment of the present invention, an average diameter D1 of a plurality of through-holes TH may be 1.5 μm to 3.5 μm, preferably 2 μm to 3 μm. Alternatively, an average shortest distance D2 between two adjacent through-holes TH may be 1.5 μm to 3.5 μm, preferably 2 μm to 3 μm. According to the present invention, a sufficient specific surface area for implementing a capacitor can be obtained, while minimizing the possibility of damage to the base 110 and improving durability.

In this case, an average height H of the plurality of through-holes TH based on a second surface 112 of the base 110 may be 3.5 μm or greater and 175 μm or less, preferably 30 μm or greater and 120 μm or less, and more preferably 40 μm or greater and 60 μm or less. As used herein, the height H of each through-hole TH may be a height from the second surface 112 of the base 110. According to the present invention, a sufficient specific surface area for implementing a capacitor can be secured, while facilitating manufacturing of the base 110.

Accordingly, a ratio H/D1 of the average height H of the plurality of through-holes TH based on the second surface 112 of the base 110 to the average diameter D1 of the plurality of through-holes TH may be 1 to 50, preferably 15 to 40, and more preferably 20 to 30. Alternatively, a ratio H/D2 of the average height H of the plurality of through-holes TH based on the second surface 112 of the base 110 to the average shortest distance D2 between two adjacent through-holes TH may be 1 to 50, preferably 15 to 40, and more preferably 20 to 30. According to the present invention, a sufficient specific surface area for implementing a capacitor can be secured, while facilitating manufacturing of the base 110.

According to an embodiment of the present invention, as shown in FIGS. 4 to 7, the first electrode layer 120 is disposed on a first surface 111, a second surface 112, and inner wall surfaces of a plurality of through-holes TH of the base 110, the first dielectric layer 130 is disposed on the first electrode layer 120 on the first surface 111, the second surface 112, and the inner wall surfaces of the plurality of through-holes TH of the base 110, a second electrode layer 140 is disposed on the first dielectric layer 130 on the first surface 111, the second surface 112, and the inner wall surfaces of the plurality of through-holes TH of the base 110, a first electrode pad 150 is connected to the first electrode layer 120, and a second electrode pad 160 is connected to the second electrode layer 140.

The capacitance of the capacitor may be expressed by Equation 1 below.

[Equation 1]

$$C = \varepsilon \frac{S}{d}$$

In Equation 1, C is capacitance, $\varepsilon$ is permittivity, S is an area of an electrode layer, and d is a distance between electrode layers. According to the embodiment, the capacitance increases as the area of the electrode layer increases.

In this case, the first electrode layer 120 may include at least one of titanium (Ti), molybdenum (Mo), tungsten (W), and indium-tin. For example, the first electrode layer 120 may include at least one of TiN, $TiO_2$, $MoO_x$, $WO_x$, ITO, or ITGO, where x is a positive integer.

As described above, when the first electrode layer 120 is disposed on the first surface 111, the second surface 112, and the inner wall surface of the through-hole TH of the base 110, a specific surface area of the capacitor increases, such that high capacitance may be secured. In addition, since gas may flow through the through-hole TH during the deposition process of the first electrode layer 120, easy and uniform deposition is achieved.

The first dielectric layer 130 may include at least one of $SiO_2$, $Si_3N_3$, $SiN_4$, ZAZ, $HfO_2$, $ZrO_2$, $Hf_xZr_yO_z$, or $Al_2O_3$, where x, y, and z are positive integers. When the material of the first dielectric layer 130 satisfies these conditions, it is easy to deposit the first dielectric layer 130 with a uniform thickness on the first electrode layer 120.

The second electrode layer 140 may include at least one of titanium (Ti), molybdenum (Mo), tungsten (W), indium-tin, copper (Cu), or aluminum (Al). For example, the second electrode layer 140 may include at least one of TiN, $TiO_2$, $MoO_x$, $WO_x$, ITO, ITGO, Cu, or Al, where x is a positive integer.

The material of the second electrode layer 140 may be the same as the material of the first electrode layer 120, but is not limited thereto. In other words, the material of the second electrode layer 140 may be different from the material of the first electrode layer 120. For example, the first electrode layer 120 may be deposited by at least one of titanium (Ti), molybdenum (Mo), tungsten (W), or indium-tin, and the second electrode layer 140 may be plated by Cu or Al.

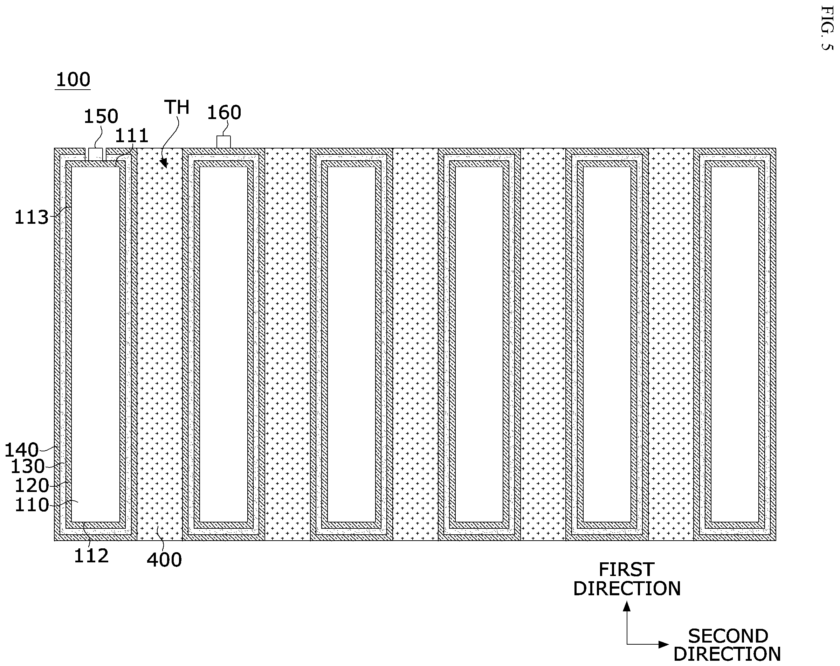

As shown in FIG. 5, the space between the second electrode layer 140 from the plurality of through-holes TH may be filled with a filler 400. As used herein, the filler 400 may be a material having insulation performance and a lower thermal expansion coefficient than the second electrode layer 140. For example, the filler 400 may include $Al_2O_3$. According to the embodiment, even when the temperature of the capacitor 100 increases, the plurality of through-holes TH are barely not thermally expanded, such that the capacitor 100 having high reliability may be provided. Alternatively, the filler 400 may include $SiO_2$. According to the embodiment, the filler 400 may serve as a passivation.

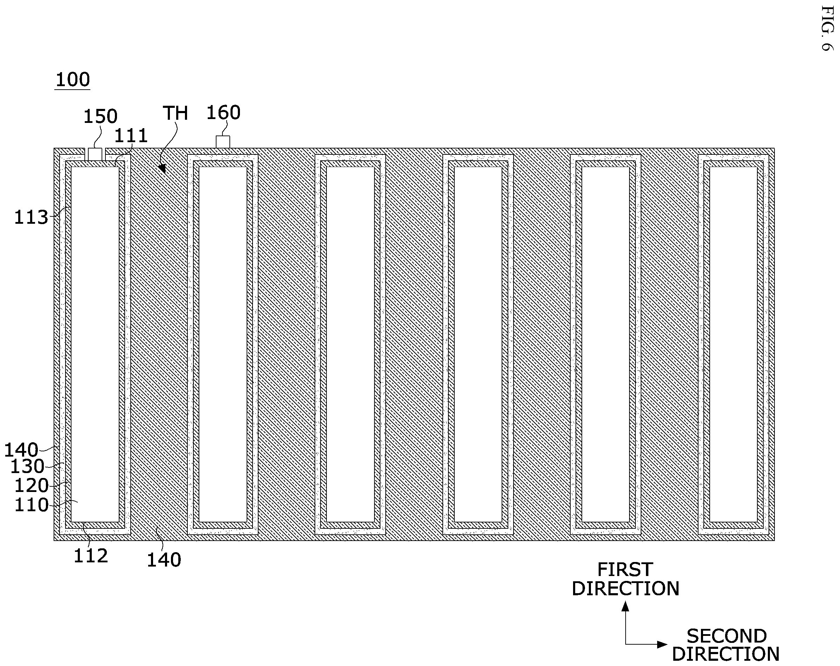

Unlike the embodiment of FIGS. 4 to 5 in which the second electrode layer 140 is deposited along the shape of the first dielectric layer 130, referring to FIG. 6, the second electrode layer 140 may be disposed to fill the plurality of through-holes TH. According to the embodiment, since the total resistance of the capacitor 100 may be reduced, a capacitor having a high reaction rate may be provided.

Meanwhile, although the foregoing description has been provided mainly with respect to an example in which the first electrode layer 120, the first dielectric layer 130, and the second electrode layer 140 are sequentially stacked on the base 110, the present invention is not limited thereto. According to an embodiment of the present invention, dielectric layers and electrode layers may further be disposed alternately on the second electrode layer 140.

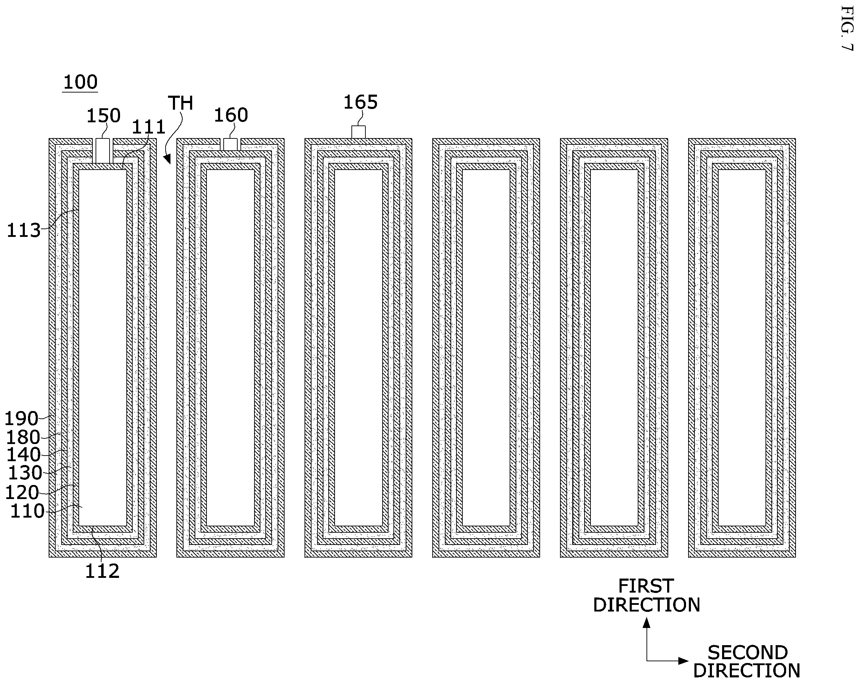

Referring to FIG. 7, a second dielectric layer 180 is disposed on the second electrode layer 140.

In this case, the second dielectric layer 180 may include at least one of $SiO_2$, $Si_3N_3$, $SiN_4$, ZAZ, $HfO_2$, $ZrO_2$, $Hf_xZr_yO_z$, or $Al_2O_3$, where x, y, and z are positive integers. When the material of the second dielectric layer 180 satisfies these conditions, it is easy to deposit the second dielectric layer 140 with a uniform thickness on the second electrode layer 140.

Next, a third electrode layer 190 is disposed on the second dielectric layer 180.

In this case, the third electrode layer 190 may include at least one of titanium (Ti), molybdenum (Mo), tungsten (W), indium-tin, copper (Cu), or aluminum (Al). For example, the third electrode layer 190 may include at least one of TiN, $TiO_2$, $MoO_x$, $WO_x$, ITO, ITGO, Cu, or Al, where x is a positive integer.

The material of the third electrode layer 190 may be the same as the materials of the first electrode layer 120 and the second electrode layer 140, but is not limited thereto. In other words, the material of the third electrode layer 190 may be different from the materials of the first electrode layer 120 and the second electrode layer 140. For example, the first electrode layer 120 and the second electrode layer 140 may include titanium (Ti), molybdenum (Mo), tungsten (W), and indium-tin, and the third electrode layer 190 may include Cu or Al. Unlike the embodiment of FIG. 7 in which the third electrode layer 190 is deposited along the shape of the second dielectric layer 180, the third electrode layer 190 may be disposed to fill the plurality of through-holes TH. According to the embodiment, since the total resistance of the capacitor 100 may be reduced, a capacitor having a high reaction rate may be provided.

Referring again to FIGS. 2 and 3, according to an embodiment of the present invention, the inner wall surface of the through-hole TH has a surface structure in the form of fine irregularities or protrusions. According to an embodiment of the present invention, the protrusions on the inner wall surface of the through-hole TH may have a height h1 of 1 nm to 50 nm, preferably 10 nm to 30 nm, and more preferably 15 nm to 25 nm. As used herein, the height h1 of the protrusion may refer to a vertical distance between the highest point and the lowest point of the protrusion, and may refer to an average height of the protrusions formed on the inner wall surface of the through-hole TH. In the present specification, the height of the protrusion may be expressed as surface roughness. As used herein, the surface roughness may be measured using a surface roughness tester and may also be referred to as roughness. The surface roughness tester may measure a cross-sectional curve using a probe, and may calculate the surface roughness using the crest line, trough line, average line, and reference length of the cross-sectional curve. In the present specification, the surface roughness may refer to arithmetic mean roughness Ra by a centerline average calculation method. In other words, in the present specification, the arithmetic mean roughness Ra may refer to an average value of absolute values of lengths from the centerline of the rough surface within the reference length L to the cross-sectional curve. The arithmetic mean roughness Ra may be obtained by Equation 2 below.

[Equation 2]

$$R_a = \frac{1}{L} \int_0^L |f(x)| dx$$

In other words, when a cross-sectional curve obtained using a probe of a surface roughness tester is extracted by a reference length L, the direction of the average line is set as an x-axis, and the height direction is set as a y-axis to be expressed as a function (f(x)), a value calculated according to Equation 2 may be obtained.

In the present specification, the surface roughness may also refer to ten-point mean roughness Rz. The ten-point mean roughness Rz represents a difference between averages obtained by, within a reference length L of a cross-sectional curve, measuring a distance between the fifth highest crest and the fifth lowest trough along a straight line that is parallel to an average line of the cross-sectional curve and does not intersect the cross-sectional curve.

According to an embodiment of the present invention, the surface roughness Ra of the inner wall surface of the through-hole TH may be 1 nm to 50 nm, preferably 10 nm to 30 nm, and more preferably 15 nm to 25 nm. When the surface roughness Ra of the inner wall surface of the through-hole TH is within this numerical range, the specific surface area of the inner wall surface of the through-hole TH increases, such that the bonding force between the inner wall surface of the through-hole TH and the first electrode layer 120 may be increased when the first electrode layer 120 is deposited or plated. However, when the surface roughness Ra of the inner wall surface of the through-hole TH exceeds this numerical range, for example, when a protrusion structure having a height of 100 nm or greater is formed on the inner wall surface of the through-hole TH, leakage current of the capacitor may be concentrated at the protrusion structure, thereby deteriorating quality of the capacitor.

According to an embodiment of the present invention, at least one of the first surface 111 or the second surface 112 of a base 110 may include a porous region. As used herein, the porosity refers to a form having a plurality of small pores. The description that at least one of the first surface 111 or the second surface 112 of the base 110 includes a porous region may indicate that a porosity of at least one of the first surface 111 or the second surface 112 of the base 110 is greater than a porosity of a middle region between the first surface 111 and the second surface 112 of the base 110.

According to an embodiment of the present invention, the porous region may have the same material as the base 110 but may be porous. For example, the porous region may be a porous silicon region. In other words, the porous region may be a silicon layer having a plurality of fine pores. According to the embodiment, a specific surface area of at least one of the first surface 111 or the second surface 112 of the base 110 may be increased. As described above, the first electrode layer 120 is in direct contact with the first surface 111 and the second surface 112 of the base 110. In this case, when at least one of the first surface 111 or the second surface 112 of the base 110 includes the porous region, the bonding force between the porous region and the first electrode layer 120 may be increased.

The porosity of at least one of the first surface 111 or the second surface 112 of the base 110 may also be expressed by surface roughness. According to an embodiment of the present invention, a surface roughness of at least one of the first surface 111 or the second surface 112 of the base 110 may be greater than a surface roughness of the inner wall surface of the through-hole TH. A thickness of the first electrode layer 120 deposited or plated on at least one of the first surface 111 or the second surface 112 of the base 110 may be greater than a thickness of the first electrode layer 120 deposited on the inner wall surface of the through-hole TH. When the surface roughness of at least one of the first surface 111 or the second surface 112 of the base 110 is greater than the surface roughness of the inner wall surface of the through-hole TH, the first electrode layer 120 may be deposited or plated on at least one of the first surface 111 or the second surface 112 of the base 110 in a planarized manner.

According to an embodiment of the present invention, the surface roughness of the first surface 111 of the base 110 may be different from the surface roughness of the second surface 112 of the base 110. For example, the surface roughness of the first surface 111 of the base 110 may be greater than the surface roughness of the second surface 112 of the base 110. When the surface roughness of the first surface 111 of the base 110 is greater than the surface roughness of the second surface 112 of the base 110, the first electrode layer 120 may be deposited or plated on the first surface 111 of the base 110 in a planarized manner, and it is easy to dispose a first electrode pad 150 and a second electrode pad 160 on a side of the first surface 111 of the base 110. Alternatively, the surface roughness of the first surface 111 of the base 110 may be less than the surface roughness of the second surface 112 of the base 110.

According to an embodiment of the present invention, when the through-hole TH is divided into an upper region T, a middle region M, and a lower region B with the same height from the first surface 111 to the second surface 112 of the base 110, the surface roughness of the inner wall surface of the middle region M may be 0.9 to 1.1 times, preferably 0.95 to 1.05 times, and more preferably 0.99 to 1.01 times the surface roughness of the inner wall surface of the upper region T, and the surface roughness of the inner wall surface of the middle region M may be 0.9 to 1.1 times, preferably 0.95 to 1.05 times, and more preferably 0.99 to 1.01 times the surface roughness of the inner wall surface of the lower region B. Accordingly, since the surface roughness of the inner wall surface of the through-hole TH is uniform from the first surface 111 to the second surface 112, resistance of the first electrode layer 120 may be maintained uniformly, and uniform capacitance may be obtained.

According to an embodiment of the present invention, when the through-hole TH is divided into an upper region T, a middle region M, and a lower region B with the same height from the first surface 111 to the second surface 112 of the base 110, a diameter of the middle region M may be 0.9 to 1.1 times, preferably 0.95 to 1.05 times, and more preferably 0.99 to 1.01 times a diameter of the upper region T, and the diameter of the middle region M may be 0.9 to 1.1 times, preferably 0.95 to 1.05 times, and more preferably 0.99 to 1.01 times a diameter of the lower region B. According to the embodiment, the resistance of the first electrode layer 120 deposited or plated on the inner wall surface of the through-hole TH may be maintained uniformly, uniform capacitance may be obtained, and a capacitance of the capacitor may be increased by increasing an aspect ratio of the through-hole TH.

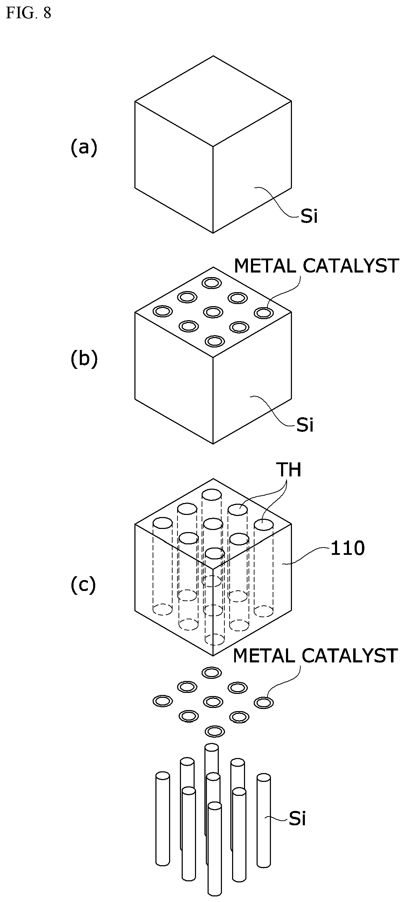

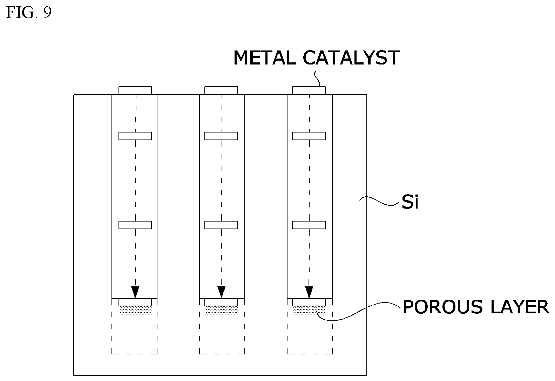

FIG. 8 shows a method of forming a through-hole of a base according to an embodiment of the present invention, and FIGS. 9 to 10 are views for describing an etching mechanism in a process of forming a through-hole of the base according to an embodiment of the present invention.

Referring to FIG. 8(a), a silicon substrate is prepared. Herein, the silicon substrate may include 90% or greater, preferably 99% or greater, and more preferably 99.999% or greater of silicon.

Referring to FIG. 8(b), a metal catalyst is disposed on an upper surface of a silicon substrate. Herein, the metal catalyst may include at least one of gold (Au), silver (Ag), titanium (Ti), or tungsten (W). The metal catalyst may be ring-shaped. In other words, the metal catalyst may be a ring-shaped metal plate having an inner diameter and an outer diameter. Although a circular ring shape is illustrated herein, it is not limited thereto, and it may be a polygonal ring shape having an outer diameter and an inner diameter, such as a square ring shape, a hexagonal ring shape, or the like. For this purpose, the ring-shaped metal catalyst may be deposited on the silicon substrate through a photoresist process and a lift off process, but is not limited thereto.

Referring to FIG. 8(c), the silicon substrate is etched to form a plurality of through-holes penetrating the upper surface and the lower surface of the base 110. Etching may be performed by a chemical reaction of silicon. For example, when wet etching is performed in the presence of HF and $H_2O_2$ while a metal catalyst including at least one of gold (Au), silver (Ag), titanium (Ti), or tungsten (W) is deposited on the upper surface of the silicon substrate, etching proceeds by an electrochemical reaction of the metal catalyst, silicon, HF, and $H_2O_2$. For example, etching may proceed according to the following chemical reactions.

[Reaction Formula 1]     $3H_2O_2+6H^+\rightarrow6H_2O+6h^+$

[Reaction Formula 2]     $6h^++2Si+12HF\rightarrow2H_2SiF_6+6H^++H_2$

In other words, $6h^+$ generated by Reaction Formula 1 in the metal catalyst may oxidize Si.

The overall reaction formula may be expressed as Reaction Formula 3 below.

[Reaction Formula 3]     $2Si+12HF+3H_2O_2\rightarrow2H_2SiF_6+6H_2O+H_2$

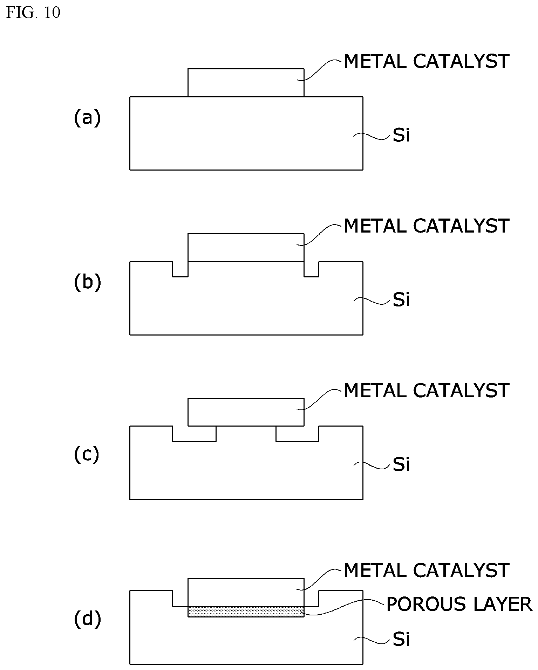

Referring to FIG. 9, holes ($h^+$) according to Reaction Formula 1 may oxidize and etch the silicon substrate in the presence of the metal catalyst. Accordingly, a porous layer may be formed beneath the metal catalyst. To describe in more detail with reference to FIG. 10, when Reaction Formulas 1 to 3 proceed while the metal catalyst is deposited on the silicon substrate as in FIG. 10(a), etching starts from a lower-side silicon substrate beneath the metal catalyst, progresses to the silicon substrate beneath the metal catalyst as shown in FIG. 10(c), and, as shown in FIG. 10(d), a porous layer may be formed in the silicon substrate beneath the metal catalyst.

Referring again to FIG. 8(c), through this process, the silicon substrate is etched according to a ring shape of the metal catalyst, and a region disposed at an inner diameter of the metal catalyst is separated from the silicon substrate in a cylindrical form.

As such, when a ring-shaped metal catalyst is used, an electrochemical reaction among the metal catalyst, silicon, HF, and $H_2O_2$ proceeds at a relatively high rate due to a small reaction area, thereby reducing a possibility that a protrusion having a height of 100 nm or greater is formed on an inner wall surface of a through-hole and enabling formation of an inner wall surface of the through-hole having a surface roughness of 1 to 50 nm. In addition, when a ring-shaped metal catalyst is used, since an electrochemical reaction among the metal catalyst, silicon, HF, and $H_2O_2$ proceeds at a high rate due to small reaction area, a possibility that the shape of the metal catalyst is deformed or etching conditions are changed may be reduced even when the etching depth increases, such that a difference between a diameter of the through-hole in the upper region and a diameter of the through-hole in the lower region may not be large. In addition, when a ring-shaped metal catalyst is used, a problem in which a metal catalyst is detached during an etching process may be prevented, and since the metal catalyst is automatically separated after etching, a separate metal catalyst removal process is not required.

As described with reference to FIGS. 8 to 10, after the through-hole TH is formed in the base 110, deposition of the first electrode layer 120, the dielectric layer 130, and the second electrode layer 130 may be sequentially performed. For example, the first electrode layer 120 may be deposited using an atomic layer deposition (ALD) process. When an ALD process is used, a material of the first electrode layer 120 may be conformally deposited in atomic units on the first surface 111 of the base 110, the second surface 112 of the base 110, and the inner wall surface of the through-hole TH. Accordingly, the first electrode layer 120 may be uniformly deposited on the first surface 111 of the base 110, the second surface 112 of the base 110, and the inner wall surface of the through-hole TH.

For example, the first dielectric layer 130 may be deposited using an ALD process. According to the embodiment, a material of the first dielectric layer 130 may be conformally and uniformly deposited in atomic units on a surface of the first electrode layer 120.

For example, the second electrode layer 140 may be deposited using an ALD process. According to the embodiment, a material of the second electrode layer 140 may be conformally deposited in atomic units on a surface of the first dielectric layer 130. Alternatively, the second electrode layer 140 may be formed on the first dielectric layer 130 by an electrolytic plating process. In this case, the second electrode layer 140 may include Al. When the second electrode layer 140 includes Al, contamination within a chamber may be prevented due to a low silicon diffusion coefficient of Al.

However, the first electrode layer 120, the first dielectric layer 130, and the second electrode layer 140 may be deposited by various processes other than an ALD process.

Next, a first electrode pad 150 is connected onto the first electrode layer 120, and a second electrode pad 160 is connected onto the second electrode layer 140. In order to connect the first electrode pad 150 to the first electrode layer 120, the second electrode layer 140 and the first dielectric layer 130 may be etched. Furthermore, the first electrode pad 150 and the second electrode pad 160 may be deposited via sputtering.

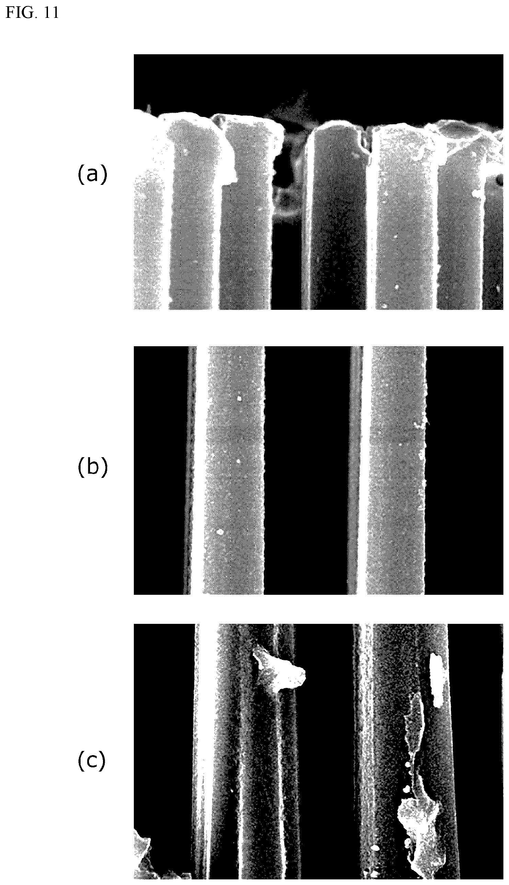

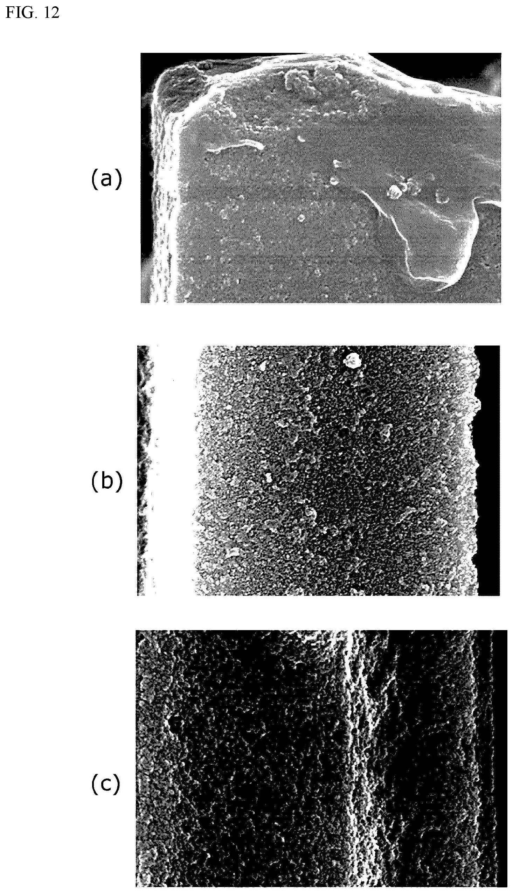

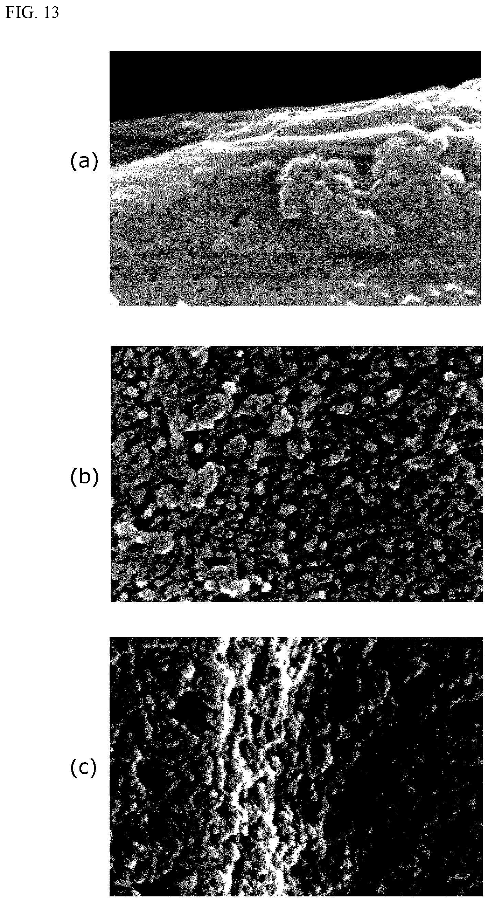

FIGS. 11 to 13 are SEM images of a structure manufactured according to an embodiment of the present invention. FIG. 11(a) is an SEM image of an upper region of a through-hole, FIG. 11(b) is an SEM image of a middle region of the through-hole, FIG. 11(c) is an SEM image of a lower region of the through-hole, FIGS. 12(a) to 12(c) are enlarged SEM images of FIGS. 11(a) to 11(c), respectively, and FIGS. 13(a) to 13(c) are enlarged SEM images of FIGS. 12(a) to 12(c), respectively.

Referring to FIGS. 11 to 13, a fine protrusion structure with a height of 1 to 50 nm may be provided on an inner wall surface of a through-hole according to an embodiment of the present invention.

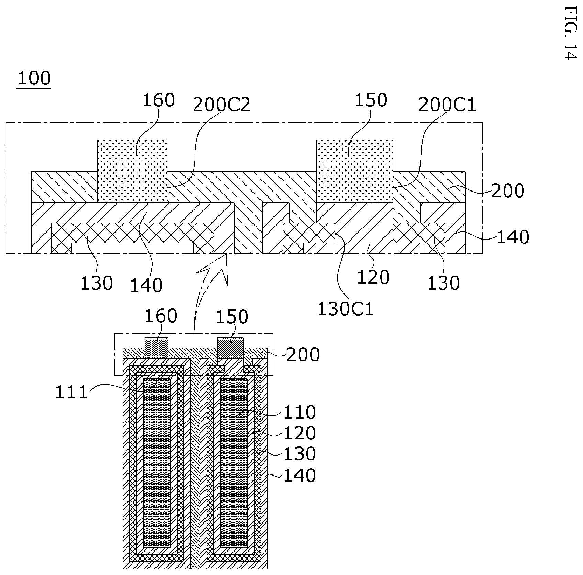

FIGS. 14 to 15 are cross-sectional views of a capacitor according to another embodiment of the present invention. Descriptions redundant to those described with reference to FIGS. 1 to 13 will be omitted.

Referring to FIG. 14, a capacitor 100 includes a base 110, a first electrode layer 120 disposed on the base 110, a first dielectric layer 130 disposed on the first electrode layer 120, a second electrode layer 140 disposed on the first dielectric layer 130, a first electrode pad 150 connected to the first electrode layer 120, and a second electrode pad 160 connected to the second electrode layer 140.

In order to arrange the first electrode pad 150 and the second electrode pad 160, according to an embodiment of the present invention, an insulating layer 200 disposed on the second electrode layer 140 on a first surface 111 of the base 110 is further included. As illustrated, the insulating layer 200 may extend into the through-hole TH to serve as a filler 400.

On the second electrode layer 140 of the first surface 111 of the base 110, the insulating layer 200 includes a first opening 200C1 and a second opening 200C2. The first electrode pad 150 may be disposed in the first opening 200C1, and the second electrode pad 160 may be disposed in the second opening 200C2. According to the embodiment, the second electrode pad 160 disposed in the second opening 200C2 may be connected to the second electrode layer 140. In order to connect the first electrode pad 150 disposed in the first opening 200C1 to the first electrode layer 120, the insulating layer 200 may extend along an edge of the first opening 200C1 to the first dielectric layer 130, and the first dielectric layer 130 may include a first hole 130C1 corresponding to the first opening 200C1. According to the embodiment, the first electrode pad 150 may be connected to the first electrode layer 120.

When the first electrode pad 150 and the second electrode pad 160 are arranged in such a structure, upper surfaces of the first electrode pad 150 and the second electrode pad 160 may be arranged to have the same height. According to the embodiment, when the capacitor 100 according to an embodiment of the present invention is mounted on a printed circuit board, it may not be necessary to separately adjust heights of the first electrode pad 150 and the second electrode pad 160, thereby improving an assembly process and enhancing bonding force between the first electrode pad 150 and the second electrode pad 160 and the printed circuit board.

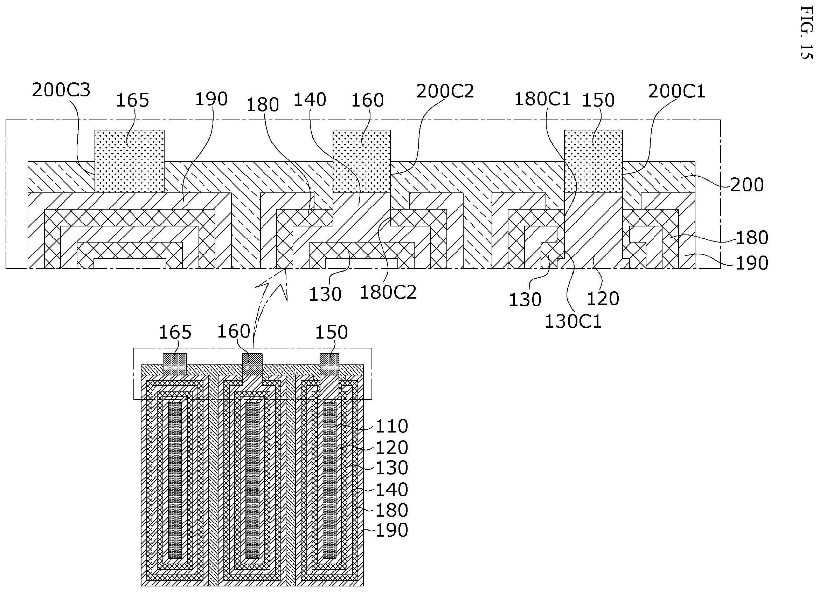

Referring to FIG. 15, a capacitor 100 includes a base 110, a first electrode layer 120 disposed on the base 110, a first dielectric layer 130 disposed on the first electrode layer 120, a second electrode layer 140 disposed on the first dielectric layer 130, a second dielectric layer 180 disposed on the second electrode layer 140, a third electrode layer 190 disposed on the second dielectric layer 180, a first electrode pad 150 connected to the first electrode layer 120, a second electrode pad 160 connected to the second electrode layer 140, and a third electrode pad 165 connected to the third electrode layer 190.

In order to arrange the first electrode pad 150, the second electrode pad 160, and the third electrode pad 165, according to an embodiment of the present invention, an insulating layer 200 disposed on the third electrode layer 190 on the first surface 111 of the base 110 is further included. As illustrated, the insulating layer 200 may extend into a through-hole TH to serve as a filler 400.

On the third electrode layer 190 of the first surface 111 of the base 110, the insulating layer 200 includes a first opening 200C1, a second opening 200C2, and a third opening 200C3. The first electrode pad 150 may be disposed in the first opening 200C1, the second electrode pad 160 may be disposed in the second opening 200C2, and the third electrode pad 165 may be disposed in the third opening 200C3. According to the embodiment, the third electrode pad 165 disposed in the third opening 200C3 may be connected to the third electrode layer 190.

In order to connect the first electrode pad 150 disposed in the first opening 200C1 to the first electrode layer 120, the insulating layer 200 may extend along an edge of the first opening 200C1 to the second dielectric layer 180, and the second dielectric layer 180 may include a first hole 180C1 corresponding to the first opening 200C1. Furthermore, the second dielectric layer 180 may extend along an edge of the first hole 180C1 to the first dielectric layer 130, and the first dielectric layer 130 may include a second hole 130C1 corresponding to the first hole 180C1. According to the embodiment, the first electrode pad 150 may be connected to the first electrode layer 120.

In order to connect the second electrode pad 160 disposed in the second opening 200C2 to the second electrode layer 140, the insulating layer 200 may extend along an edge of the second opening 200C2 to the second dielectric layer 180, and the second dielectric layer 180 may include a third hole 180C2 corresponding to the second opening 200C2. Accordingly, the second electrode pad 160 may be connected to the second electrode layer 140.

When the first electrode pad 150, the second electrode pad 160, and the third electrode pad 165 are arranged in such a structure, upper surfaces of the first electrode pad 150, the second electrode pad 160, and the third electrode pad 165 may be arranged to have the same height. According to the embodiment, when the capacitor 100 according to an embodiment of the present invention is mounted on a printed circuit board, it may not be necessary to separately adjust heights of the first electrode pad 150, the second electrode pad 160, and the third electrode pad 165, thereby improving an assembly process and enhancing bonding force between the first electrode pad 150, the second electrode pad 160, and the third electrode pad 165 and the printed circuit board.

Although the description has been provided mainly with respect to an embodiment in which a silicon substrate according to the present invention is applied to a capacitor, the present invention is not limited thereto. A silicon substrate according to an embodiment of the present invention may also be applied to an interposer or a MEMS TSV.

The foregoing description has been provided with reference to exemplary embodiments of the present invention. However, it shall be understood by those skilled in the art that various modifications and changes may be made to the present invention without departing from the spirit and scope of the present invention as set forth in the appended claims.

## Claims

1. A capacitor comprising:

   a base including a through-hole penetrating from a first surface to a second surface opposite to the first surface;
   a first electrode layer disposed on the first surface, the second surface, and an inner wall surface of the through-hole of the base;
   a first dielectric layer disposed on the first electrode layer on the first surface, the second surface, and the inner wall surface of the through-hole of the base; and

a second electrode layer disposed on the first dielectric layer on the first surface, the second surface, and the inner wall surface of the through-hole of the base,
wherein the base includes silicon, and
wherein a surface roughness of the inner wall surface of the through-hole is 1 nm to 50 nm.

2. The capacitor of claim 1, wherein at least one of the first surface or the second surface includes a porous region.

3. The capacitor of claim 1, wherein a surface roughness of at least one of the first surface or the second surface is different from the surface roughness of the inner wall surface of the through-hole.

4. The capacitor of claim 3, wherein the surface roughness of the first surface is different from the surface roughness of the second surface.

5. The capacitor of claim 1, wherein, when the through-hole is divided into an upper region, a middle region, and a lower region having equal heights from the first surface to the second surface of the base, a surface roughness of an inner wall surface of the middle region is 0.9 to 1.1 times a surface roughness of an inner wall surface of the upper region and 0.9 to 1.1 times a surface roughness of an inner wall surface of the lower region.

6. The capacitor of claim 1, wherein, when the through-hole is divided into an upper region, a middle region, and a lower region having equal heights from the first surface to the second surface of the base, a diameter of the middle region is 0.9 to 1.1 times a diameter of the upper region and 0.9 to 1.1 times a diameter of the lower region.

7. The capacitor of claim 1, wherein the first electrode layer and the second electrode layer include at least one of titanium (Ti), molybdenum (Mo), tungsten (W), indium-tin, or copper (Cu).

8. The capacitor of claim 7, further comprising a passivation layer disposed on the second electrode layer,
wherein the passivation layer includes $SiO_2$.

9. A silicon substrate comprising:

a base including a through-hole penetrating from a first surface to a second surface opposite to the first surface,
wherein the base includes silicon,
wherein a surface roughness of an inner wall surface of the through-hole is 1 nm to 50 nm, and
wherein, when the through-hole is divided into an upper region, a middle region, and a lower region having equal heights from the first surface to the second surface of the base, a surface roughness of an inner wall surface of the middle region is 0.9 to 1.1 times a surface roughness of an inner wall surface of the upper region and 0.9 to 1.1 times a surface roughness of an inner wall surface of the lower region.

10. A silicon substrate comprising:

a base including a through-hole penetrating from a first surface to a second surface opposite to the first surface,
wherein the base includes silicon,
wherein a surface roughness of an inner wall surface of the through-hole is 1 nm to 50 nm, and
wherein, when the through-hole is divided into an upper region, a middle region, and a lower region having equal heights from the first surface to the second surface of the base, a diameter of the middle region is 0.9 to 1.1 times a diameter of the upper region and 0.9 to 1.1 times a diameter of the lower region.

FIG. 1

FIG. 2

FIG. 3

110

111

112

113

TH

TH

H

D1

D2

T

M

B

h1

h2

FIRST DIRECTION

SECOND DIRECTION

FIG. 4

FIG. 5

FIG. 6

FIG. 7

FIG. 8

(a)

Si

METAL CATALYST

(b)

Si

TH

110

(c)

METAL CATALYST

Si

FIG. 9

METAL CATALYST

Si

POROUS LAYER

FIG. 10

(a) METAL CATALYST

Si

(b) METAL CATALYST

Si

(c) METAL CATALYST

Si

(d) METAL CATALYST

POROUS LAYER

Si

FIG. 11

(a)

(b)

(c)

FIG. 12

(a)

(b)

(c)

FIG. 13

FIG. 14

FIG. 15

EP 4 776 825 A1

200C3  165  190  180  140  160  200C2  180C1  150  200C1

200

180

190

130  180C2

130  120

130C1

165  160  150

110
120
130
140
180
190

## INTERNATIONAL SEARCH REPORT

| International application No. |
|---|
| **PCT/KR2024/012789** |

| A. | CLASSIFICATION OF SUBJECT MATTER |
|---|---|
| | **H10N 97/00**(2023.01)i; **H01L 27/08**(2006.01)i |

According to International Patent Classification (IPC) or to both national classification and IPC

| B. | FIELDS SEARCHED |
|---|---|

Minimum documentation searched (classification system followed by classification symbols)

H10N 97/00(2023.01); H01G 4/12(2006.01); H01G 4/228(2006.01); H01G 4/33(2006.01); H01L 21/8242(2006.01); H01L 27/108(2006.01); H01L 29/786(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 캐패시터(capacitor), 전극층(electrode layer), 유전체(dielectric), 금속층(metal layer), 관통 구멍(through hole)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2020-027821 A (TAIYO YUDEN CO., LTD.) 20 February 2020 (2020-02-20)<br>See paragraphs [0029]-[0030], [0035] and [0039]-[0041]; and figure 2. | 1-10 |
| Y | JP 2018-182283 A (DAINIPPON PRINTING CO., LTD.) 15 November 2018 (2018-11-15)<br>See paragraphs [0035]-[0036], [0059]-[0082] and [0106]; and figures 1, 5-12 and 20. | 1-10 |
| Y | KR 10-2013-0132519 A (TESSERA, INC.) 04 December 2013 (2013-12-04)<br>See paragraphs [0103]-[0116]; and figure 7a. | 2 |
| A | JP 2015-103742 A (MICRON TECHNOLOGY INC.) 04 June 2015 (2015-06-04)<br>See paragraphs [0017]-[0076]; and figures 1-4. | 1-10 |
| A | KR 10-0290270 B1 (SHARP KABUSHIKI KAISHA) 01 June 2001 (2001-06-01)<br>See paragraphs [0033]-[0063]; and figures 1-3. | 1-10 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **29 November 2024** | **09 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/012789**

| Patent document cited in search report | | | Publication date (day/month/year) | Patent family member(s) | | | Publication date (day/month/year) |
|---|---|---|---|---|---|---|---|
| JP | 2020-027821 | A | 20 February 2020 | JP | 7160594 | B2 | 25 October 2022 |
| | | | | US | 2020-0051749 | A1 | 13 February 2020 |
| JP | 2018-182283 | A | 15 November 2018 | JP | 2022-028847 | A | 16 February 2022 |
| KR | 10-2013-0132519 | A | 04 December 2013 | CN | 103348442 | A | 09 October 2013 |
| | | | | EP | 2649639 | A1 | 16 October 2013 |
| | | | | JP | 2014-505354 | A | 27 February 2014 |
| | | | | KR | 10-2012-0064610 | A | 19 June 2012 |
| | | | | TW | 201232580 | A | 01 August 2012 |
| | | | | US | 2012-0146182 | A1 | 14 June 2012 |
| | | | | WO | 2012-078213 | A1 | 14 June 2012 |
| JP | 2015-103742 | A | 04 June 2015 | None | | | |
| KR | 10-0290270 | B1 | 01 June 2001 | JP | 10-107291 | A | 24 April 1998 |
| | | | | US | 5981974 | A | 09 November 1999 |

Form PCT/ISA/210 (patent family annex) (July 2022)